# EUROPEAN PATENT APPLICATION

(11) **EP 4 814 355 A1**
(43) Date of publication of application: **30.09.2026**
(21) Application number: 24893793.0
(22) Date of filing: 11.07.2024
(51) Int. Cl.: F16K 31/06

(54) **SIGNAL OUTPUT CIRCUIT FOR SOLENOID VALVE, AND DRIVE CONTROL METHOD**

(30) Priority: 21.11.2023 JP 2023197377
(71) Applicant: SMC Corporation, Tokyo 104-0031 (JP)
(72) Inventor: KODATE, Yoshinori, Kashiwa-shi, Chiba 277-0871 (JP)
(74) Representative: Keil & Schaafhausen Patentanwälte PartGmbB
(86) International application number: PCT/JP2024/025065
(87) International publication number: WO 2025/109798

(57) **Abstract**

This signal output circuit (40) for a solenoid valve (10) comprises: a first smoothing circuit (110) which smooths an input voltage (Vi) corresponding to a drive current flowing through a solenoid coil (30); a second smoothing circuit (120) which has a second capacitor (C2) and smooths the input voltage; a comparator (130) which outputs an output signal (So) based on a comparison between a first voltage (V1) from the first smoothing circuit and a second voltage (V2) from the second smoothing circuit; and a discharge circuit (150) which discharges the charge accumulated in the second capacitor.

## Description

### TECHNICAL FIELD

The present invention relates to a signal output circuit for a solenoid valve, and a drive control method for a solenoid valve.

### Description of the Related Art:

CN 110998761 A discloses a diagnostic device for a solenoid valve. When the solenoid is energized, the solenoid current initially increases. The solenoid current then decreases and then increases again. The reference characteristics of the solenoid current waveforms are obtained in advance. When a waveform of the solenoid current detected during the operation of the solenoid valve changes from the reference characteristics, the solenoid valve is diagnosed as being deteriorated.

### BACKGROUND ART

Conventionally, in order to reduce power consumption of a solenoid valve, a solenoid coil for driving the solenoid valve is energized in periodic pulses after the solenoid valve has been started to be driven. In the periodic pulse energization, an energized state in which a drive current flows through the solenoid coil and a non-energized state in which no drive current flows through the solenoid coil are alternately repeated. According to the diagnosis device for a solenoid valve disclosed in CN 110998761 A, even when an abnormality occurs in which the solenoid valve does not enter a valve open state but remains in a valve closed state, an increase or decrease in the drive current similar to that at the time of valve opening, can be detected due to the periodic pulse energization. In this case, there is a problem that the solenoid valve is erroneously detected as being in the valve open state.

An object of the present invention is to solve the aforementioned problems.

A first aspect of the present invention is characterized by a signal output circuit for a solenoid valve, the signal output circuit including a first smoothing circuit including a first capacitor and configured to smooth an input voltage corresponding to a drive current flowing through a solenoid coil configured to drive the solenoid valve, a second smoothing circuit including a second capacitor and configured to smooth the input voltage, the second smoothing circuit having a time constant larger than a time constant of the first smoothing circuit, a comparator including a first input terminal to which a first voltage obtained by smoothing the input voltage by the first smoothing circuit is input, a second input terminal to which a second voltage corresponding to a smoothed voltage obtained by smoothing the input voltage by the second smoothing circuit is input, and an output terminal from which an output signal based on a comparison between the first voltage and the second voltage is output, and a discharge circuit connected to the second capacitor and configured to switch whether or not to discharge electric charge accumulated in the second capacitor, wherein the discharge circuit includes a first switching element and a discharge resistor connected in series.

A second aspect of the present invention is characterized by a drive control method for a solenoid valve by a drive circuit including the signal output circuit for the solenoid valve according to the first aspect, the drive control method including, a drive starting step of performing second ON control of turning on a second switching element connected to the solenoid coil to bring the solenoid coil into an energized state in which the drive current flows through the solenoid coil, in order to start driving the solenoid valve, a pulse energization step of, in a case where a predetermined time period elapses after the second ON control is performed in the drive starting step, alternately and repeatedly performing, on the second switching element, second OFF control of turning off the second switching element to bring the solenoid coil into a non-energized state in which the drive current does not flow through the solenoid coil and the second ON control, and alternately and repeatedly performing, on the first switching element, first ON control of turning on the first switching element in the non-energized state to cause the discharge circuit to discharge the electric charge and first OFF control of turning off the first switching element in the energized state, and a change in a state detection step of detecting, on a basis of the output signal, a change in a state of a voltage from a first state in which the first voltage is higher than the second voltage to a second state in which the first voltage is lower than the second voltage.

According to the present invention, even in the case where the solenoid coil is energized in periodic pulses, it is possible to prevent the solenoid valve in the valve closed state from being erroneously detected as being in the valve open state.

The above and other objects, features, and advantages of the present invention will be easily understood from the following description of preferred embodiments, which will be described with reference to the accompanying drawings.

### BRIEF DESCRIPTION OF DRAWINGS

[FIG. 1] FIG. 1 is a diagram exemplifying a drive circuit of a solenoid valve;
[FIG. 2] FIG. 2 is a diagram exemplifying the changes in a first voltage and a second voltage with time in the case where the solenoid valve is normally opened;
[FIG. 3] FIG. 3 is a diagram exemplifying the changes in the first voltage and the second voltage with time in the case where the solenoid valve is not normally opened;
[FIG. 4] FIG. 4 is a flowchart illustrating an example of a processing sequence of a drive control process of the solenoid valve; and
[FIG. 5] FIG. 5 is a flowchart illustrating another example of the processing sequence of the drive control process of the solenoid valve.

### DETAILED DESCRIPTION OF THE INVENTION

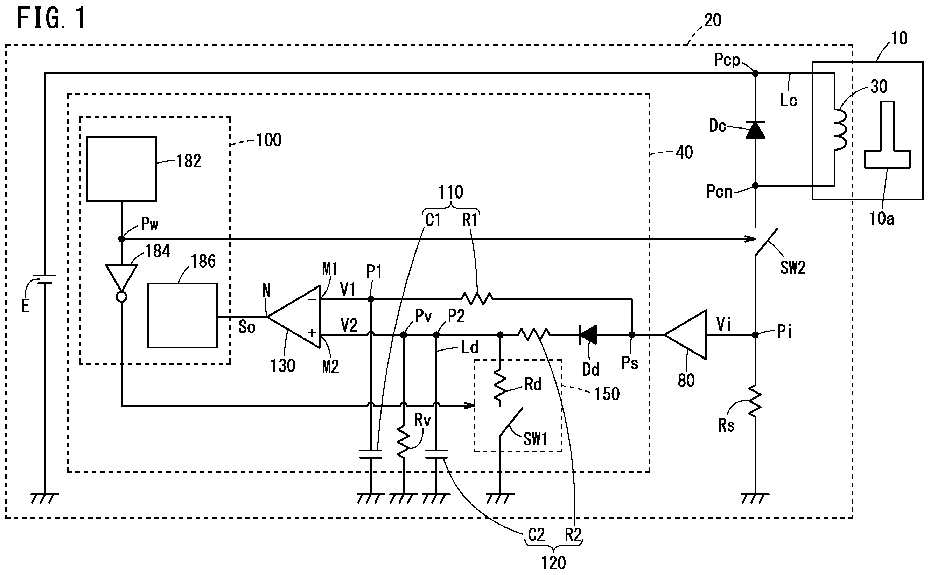

FIG. 1 is a diagram exemplifying a drive circuit 20 of a solenoid valve 10. The drive circuit 20 includes a power source E, a solenoid coil 30 for driving the solenoid valve 10, a signal output circuit 40 according to an embodiment of the present invention, and an amplifier 80.

When a drive current from the power source E flows through the solenoid coil 30, a magnetic force is generated. A movable iron core 10a in the solenoid valve 10 is moved by the generated magnetic force. The solenoid valve 10 changes from a valve closed state to a valve open state due to the movement of the movable iron core 10a. In the valve closed state, the movable iron core 10a abuts against a valve seat, thereby blocking the flow path from an inlet port to an outlet port of the solenoid valve 10. In the valve open state, the movable iron core 10a is separated from the valve seat, so that the flow path from the inlet port to the outlet port is communicated.

The drive circuit 20 has a current detection resistor Rs connected in series with the solenoid coil 30. One end of the current detection resistor Rs is connected to the ground. The negative electrode of the power source E is also connected to the ground. The signal output circuit 40 is connected to a position Pi to which another end of the current detection resistor Rs is connected, via the amplifier 80. Therefore, an input voltage Vi at the position Pi is input to the signal output circuit 40 via the amplifier 80. The input voltage Vi changes according to the drive current flowing through the solenoid coil 30.

The amplifier 80 is, for example, an operational amplifier. An input terminal of the amplifier 80 is connected to the position Pi. An output terminal of the amplifier 80 is connected to the signal output circuit 40. The amplifier 80 amplifies the input voltage Vi input from the input terminal to the amplifier 80. The input voltage Vi is amplified by the amplifier 80 and output from the output terminal of the amplifier 80. The amplified input voltage Vi is input to the signal output circuit 40. The amplifier 80 enables the signal output circuit 40 to react sensitively to a change in the input voltage Vi.

The drive circuit 20 includes a second switching element SW2 connected in series with the solenoid coil 30 and a current detection resistor Rs. When the second switching element SW2 is turned on, the solenoid coil 30 enters an energized state in which the drive current from the power source E flows through the solenoid coil 30. When the second switching element SW2 is turned off, the solenoid coil 30 enters a non-energized state in which the drive current from the power source E does not flow through the solenoid coil 30.

In the present embodiment, the signal output circuit 40 performs both the second ON control for turning on the second switching element SW2 and the second OFF control for turning off the second switching element SW2. In the case where the second switching element SW2 is a MOSFET, the signal output circuit 40 turns on or off the gate voltage via a driver of the MOSFET. In the case where the gate voltage is ON, the second switching element SW2 is turned on. In the case where the gate voltage is OFF, the second switching element SW2 is turned off.

The drive circuit 20 has a diode Dc connected to both ends of the solenoid coil 30. A cathode of the diode Dc is connected to a position Pcp at one end of the solenoid coil 30. One end of the solenoid coil 30 and the cathode of the diode Dc are both connected to the positive electrode of the power source E. An anode of the diode Dc is connected to the position Pcn of another end of the solenoid coil 30. The other end of the solenoid coil 30 and the anode of the diode Dc are both connected to the ground via the second switching element SW2 and the current detection resistor Rs.

The diode Dc is connected in series with the second switching element SW2, similarly to the solenoid coil 30. When the second switching element SW2 is in an OFF state, the diode Dc and the solenoid coil 30 form a closed loop Lc. In the case where the second switching element SW2 is switched from ON to OFF, the induced current generated in the solenoid coil 30 transiently circulates through the closed loop Lc. The second switching element SW2 is not included in the closed loop Lc. Therefore, the second switching element SW2 is prevented from being damaged by the induced current. That is, the diode Dc protects the second switching element SW2.

The signal output circuit 40 includes a control unit 100, a first smoothing circuit 110, a second smoothing circuit 120, a voltage dividing resistor Rv, a comparator 130, a discharge circuit 150, and a diode Dd. The control unit 100 need not necessarily be included in the signal output circuit 40, but in the present embodiment, the control unit 100 is included in the signal output circuit 40. The first smoothing circuit 110 and the second smoothing circuit 120 are both connected to the amplifier 80 at a position Ps on an output line from the output terminal of the amplifier 80.

The first smoothing circuit 110 includes a first resistor R1 and a first capacitor C1. One end of the first resistor R1 is connected to the output terminal of the amplifier 80. Another end of the first resistor R1 is connected to a first input terminal M1, which is an inverting input terminal of the comparator 130. One end of the first capacitor C1 is connected to a position P1 between the other end of the first resistor R1 and the first input terminal M1 of the comparator 130. Another end of the first capacitor C1 is connected to the ground.

The first smoothing circuit 110 smooths the input voltage Vi amplified by the amplifier 80. The first voltage V1, which is obtained by smoothing the input voltage Vi by the first smoothing circuit 110, is input to the first input terminal M1 of the comparator 130.

The second smoothing circuit 120 includes a second resistor R2 and a second capacitor C2. One end of the second resistor R2 is connected to the output terminal of the amplifier 80 via the diode Dd. Another end of the second resistor R2 is connected to a second input terminal M2, which is a non-inverting input terminal of the comparator 130. One end of the second capacitor C2 is connected to a position P2 between the other end of the second resistor R2 and the second input terminal M2 of the comparator 130. Another end of the second capacitor C2 is connected to the ground. One end of the voltage dividing resistor Rv is connected to a position Pv between the position P2 and the second input terminal M2 of the comparator 130. Another end of the voltage dividing resistor Rv is connected to the ground.

The second smoothing circuit 120 smooths the input voltage Vi amplified by the amplifier 80. The voltage dividing resistor Rv divides the smoothed voltage obtained by smoothing the input voltage Vi by the second smoothing circuit 120. That is, the smoothed voltage is divided by the voltage dividing resistor Rv in accordance with the ratio of the resistance value of the voltage dividing resistor Rv to the sum of the resistance value of the voltage dividing resistor Rv and the resistance value of the second resistor R2. A second voltage V2 is obtained according to the smoothed voltage. The second voltage V2 obtained by dividing the smoothed voltage by the voltage dividing resistor Rv is input to the second input terminal M2 of the comparator 130.

The resistance value of the first resistor R1, the capacitance value of the first capacitor C1, the resistance value of the second resistor R2, and the capacitance value of the second capacitor C2 are determined in advance such that a time constant of the second smoothing circuit 120 is larger than a time constant of the first smoothing circuit 110. It is preferable for the capacitance value of the second capacitor C2 to be larger than the capacitance value of the first capacitor C1. Accordingly, the change in the second voltage V2 can be delayed relative to the change in the first voltage V1. The resistance value of the voltage dividing resistor Rv is preferably larger than the resistance value of the second resistor R2. Accordingly, a change in the state, which will be described later, relating to the magnitude relationship between the first voltage V1 and the second voltage V2 can be stably detected.

The discharge circuit 150 includes a first switching element SW1 and a discharge resistor Rd connected in series. The discharge circuit 150 is connected to both ends of the second capacitor C2. When the first switching element SW1 is turned off, electric charge is accumulated in the second capacitor C2.

When the first switching element SW1 is in the ON state, the second capacitor C2 and the discharge resistor Rd form a closed loop Ld. In the case where the first switching element SW1 is switched from OFF to ON, the charge accumulated in the second capacitor C2 is consumed by the discharge resistor Rd and discharged. By setting the resistance value of the discharge resistor Rd to be small, the charge accumulated in the second capacitor C2 can be discharged rapidly.

The discharge circuit 150 can switch whether or not to discharge the charge accumulated in the second capacitor C2 by turning on or off the first switching element SW1. The signal output circuit 40 performs both the first ON control for turning on the first switching element SW1 and the first OFF control for turning off the first switching element SW1.

In the case where the first switching element SW1 is a MOSFET, the signal output circuit 40 turns on or off the gate voltage via a driver of the MOSFET. In the case where the gate voltage is ON, the first switching element SW1 is turned on. In the case where the gate voltage is OFF, the first switching element SW1 is turned off.

The discharge resistor Rd may be disposed between the second resistor R2 and a position P2 where the second resistor R2 and the second capacitor C2 of the second smoothing circuit 120 are connected. In this case, the discharge resistor Rd contributes to the smoothing of the voltage Vi by the second smoothing circuit 120, together with the second resistor R2 and the second capacitor C2.

As described above, the diode Dd is disposed between the amplifier 80 and the second resistor R2. A cathode of the diode Dd is connected to the second resistor R2. An anode of the diode Dd is connected to the amplifier 80 and the first smoothing circuit 110. The diode Dd allows the second smoothing circuit 120 to function as a peak hold circuit capable of holding a peak value of the second voltage V2 as long as the first switching element SW1 is off.

The comparator 130 includes the first input terminal M1 and the second input terminal M2 described above and an output terminal N. The output terminal N outputs, to the control unit 100, an output signal So based on a comparison between the first voltage V1 input to the first input terminal M1 and the second voltage V2 input to the second input terminal M2.

The control unit 100 includes a processor such as a CPU (Central Processing Unit) or a GPU (Graphics Processing Unit) or the like, and a memory that stores a program to be executed by the processor. The control unit 100 may be realized by an integrated circuit such as an ASIC (Application Specific Integrated Circuit) or an FPGA (Field Programmable Gate Array) or the like, or alternatively, an electronic circuit including a discrete device.

The control unit 100 includes a switching control unit 182, a NOT circuit 184, and a detection unit 186. The switching control unit 182 performs the second ON control and the second OFF control on the second switching element SW2 described above. The switching control unit 182 further performs the first ON control and the first OFF control on the first switching element SW1 described above.

In the present embodiment, as shown in FIG. 1, the control line extending from the switching control unit 182 branches at a position Pw, and the branched control lines are directed to the second switching element SW2 and the first switching element SW1, respectively. The NOT circuit 184 is disposed on the control line between the position Pw and the first switching element SW1.

The switching control unit 182 alternately repeats the second OFF control and the second ON control on the second switching element SW2. Thus, the solenoid coil 30 is energized in periodic pulses. The solenoid coil 30 repeats an energized state and a non-energized state.

The NOT circuit 184 reverses the phases of the second OFF control and the second ON control for the second switching element SW2, thereby implementing the first ON control and the first OFF control for the first switching element SW1. In this way, the switching control unit 182 can alternately repeat the first ON control and the first OFF control on the first switching element SW1. The first switching element SW1 and the second switching element SW2 are not turned on simultaneously.

The detection unit 186 is connected to the output terminal N of the comparator 130. The detection unit 186 acquires the output signal So output from the comparator 130. The detection unit 186 detects a change in the state of the voltage related to the first voltage V1 and the second voltage V2 based on the acquired output signal So. The detection of the change in the state of the voltage that occurs for the first time after the start of driving of the solenoid valve 10 can be associated with the detection of the valve open state of the solenoid valve 10 by using, for example, an external device or the like. That is, the output signal So from the comparator 130 can be used for determining the valve open state of the solenoid valve 10. A specific example of the change in the state of the voltage detected by the detection unit 186 based on the output signal So from the comparator 130 will be described below.

As described above, both the first smoothing circuit 110 and the second smoothing circuit 120 smooth the amplified input voltage Vi. As described above, the time constant of the second smoothing circuit 120 is larger than the time constant of the first smoothing circuit 110. Therefore, in the case where the input voltage Vi rises with time, the smoothing of the input voltage Vi by the second smoothing circuit 120 is delayed compared to the smoothing of the input voltage Vi by the first smoothing circuit 110.

In this case, the first voltage V1 input to the first input terminal M1 of the comparator 130 may be higher than the second voltage V2 input to the second input terminal M2. Therefore, for example, the output signal So indicating the Low level is output from the output terminal N of the comparator 130. The detection unit 186 detects that the first voltage V1 is higher than the second voltage V2 based on the output signal So indicating the Low level.

Even in the case where the input voltage Vi drops with time, the smoothing of the input voltage Vi by the second smoothing circuit 120 is delayed compared to the smoothing of the input voltage Vi by the first smoothing circuit 110. In this case, the first voltage V1 input to the first input terminal M1 may be lower than the second voltage V2 input to the second input terminal M2. Therefore, for example, the output signal So indicating the High level is output from the output terminal N. The detection unit 186 detects that the first voltage V1 is lower than the second voltage V2 based on the signal So indicating the High level.

Therefore, in the case where the input voltage Vi rises and then falls with time, the detection unit 186 can detect, on the basis of the output signal So, a change in the state of the voltage, that is, a change from a first state in which first voltage V1 is higher than second voltage V2 to a second state in which first voltage V1 is lower than second voltage V2.

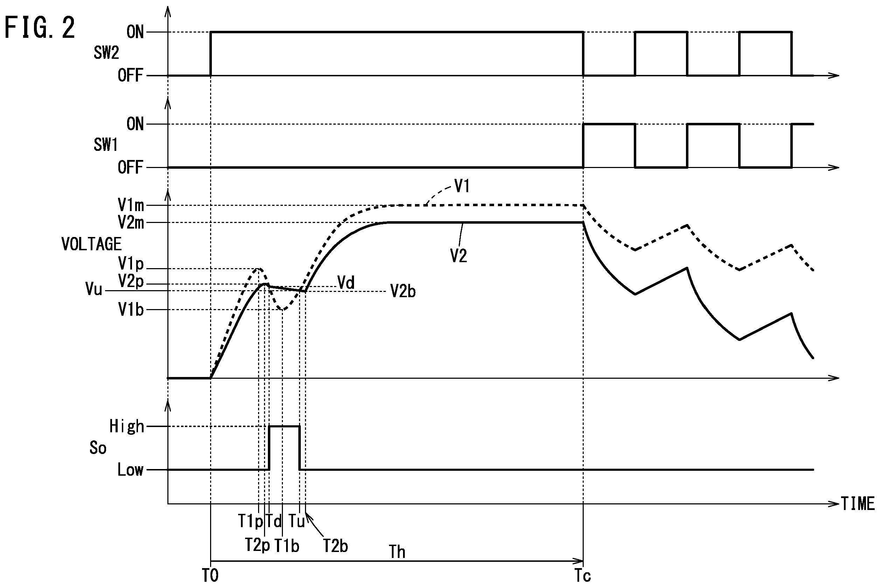

FIG. 2 is a diagram exemplifying the changes in the first voltage V1 and the second voltage V2 with time in the case where the solenoid valve 10 is normally opened. In FIG. 2, the change in the output signal So, the ON/OFF change of the first switching element SW1, and the ON/OFF change of the second switching element SW2 are also illustrated.

In order to start driving the solenoid valve 10, the switching control unit 182 of the control unit 100 performs, at time T0, the second ON control on the second switching element SW2 and the first OFF control on the first switching element SW1. The second switching element SW2 is turned on, and the first switching element SW1 is turned off. Since a large amount of electric power is required to open the solenoid valve 10, the periodic pulse energization is not performed for the solenoid coil 30. That is, continuous energization is performed for the solenoid coil 30.

After the start of the driving of the solenoid valve 10, both the first voltage V1 and the second voltage V2 rise. However, the smoothing of the second smoothing circuit 120 is delayed compared to the smoothing of the first smoothing circuit 110. Therefore, the rise of the second voltage V2 is slower than the rise of the first voltage V1. Since the first voltage V1 is higher than the second voltage V2, the comparator 130 outputs the output signal So indicating the Low level from the output terminal N. The detection unit 186 detects that the first voltage V1 is higher than the second voltage V2 based on the output signal So from the comparator 130. The solenoid valve 10 remains in the valve closed state.

At time T1p, which is later than time T0, the first voltage V1 rises to voltage V1p. From time T0 to time T1p, the second voltage V2 also rises, but is lower than the first voltage V1. In the case where the solenoid valve 10 is normally opened, the movable iron core 10a in the solenoid valve 10 starts to move at time T1p. That is, the solenoid valve 10 changes from the valve closed state to the valve open state. As the movable iron core 10a moves in the solenoid coil 30, the inductance increases, and the voltage Vi drops. After time T1p, the first voltage V1 drops as the voltage Vi drops.

As described above, the smoothing of the second smoothing circuit 120 is delayed compared to the smoothing of the first smoothing circuit 110. Therefore, time T2p at which the second voltage V2 changes from rising to falling is later than the above-described time T1p. The second voltage V2 rises to the voltage value V2p at time T2p, and then gradually drops with the drop in the input voltage Vi. The second smoothing circuit 120 may function as a peak hold circuit. Therefore, the drop of the second voltage V2 is more slowly than the drop of first voltage V1. Therefore, at time T1p and time Td after time T2p, both the first voltage V1 and the second voltage V2 drop to the voltage value Vd.

The first state in which the first voltage V1 is higher than the second voltage V2 continues from time T0 to time Td. When time Td has passed, the state changes from the first state to the second state in which the first voltage V1 is lower than the second voltage V2. Such a change in the state of voltage occurs first after the start of driving of the solenoid valve 10. Since the output signal So changes from Low to High, the detection unit 186 detects this first change in the state. The detection of the first change in the state change can be associated with the detection of the valve open state of the solenoid valve 10 by using, for example, an external device or the like.

At time T1b after time Td, the solenoid valve 10 is fully opened, and the movable iron core 10a stops moving. At time T1b, the first voltage V1 drops to a voltage value V1b. Since the inductance does not change after time T1b, the drop in the first voltage V1 stops at the voltage value V1b, and the first voltage V1 starts to rise again. Time T2b at which the second voltage V2 changes from dropping to rising is later than time T1b described above. In the example shown in FIG. 2, at time Tu after time T1b and before time T2b, the rising first voltage V1 and the falling second voltage V2 both indicate the voltage value Vu.

The second state in which the first voltage V1 is lower than the second voltage V2 continues from time Td to time Tu. When the time Tu has passed, the second state changes to the first state in which the first voltage V1 is higher than the second voltage V2. The output signal So is changed from High to Low again. At time T2b after time Tu, the second voltage V2 drops to a voltage value V2b. The drop of the second voltage V2 stops at the voltage value V2b, and the second voltage V2 starts to rise again in the same manner as the first voltage V1. As described above, since the rise of the second voltage V2 is slower than the rise of the first voltage V1, the first state continues even after time T2b.

When the first voltage V1 rises to a voltage value V1m, the first voltage V1 is maintained at the voltage value V1m. When the second voltage V2 rises to a voltage value V2m, the second voltage V2 is maintained at the voltage value V2m. The voltage value V1m is equal to the voltage value obtained by amplifying the input voltage Vi with the amplifier 80. The voltage value V2m is equal to a voltage value obtained by dividing, by means of the voltage dividing resistor Rv, a voltage obtained by amplifying the input voltage Vi with the amplifier 80.

That is, the first state in which the first voltage V1 is higher than the second voltage V2 is maintained by the voltage dividing resistor Rv. Therefore, the comparator 130 continues to output the output signal So indicating the Low level from the output terminal N.

When the solenoid valve 10 is in the valve open state, since a large amount of power is not required, the periodic pulse energization is performed for the purpose of a power saving operation. Time at which the periodic pulse energization is started is defined as time Tc at which a predetermined time period Th has elapsed from time T0. In the example illustrated in FIG. 2, the time Tc is later than the time Tu. Along with the periodic pulse energization started at time Tc, the switching control unit 182 alternately repeats the first OFF control and the first ON control on the first switching element SW1. That is, the switching control unit 182 energizes the solenoid coil 30 in periodic pulses.

In the case where the detection unit 186 detects the first change in the state at time Td described above, the switching control unit 182 may alternately repeat the second OFF control and the second ON control on the second switching element SW2 before the predetermined time period Th elapses. In this case, the switching control unit 182 may start to energize the solenoid coil 30 in periodic pulses after standby time period from time Td has elapsed. The standby time period is a time period from time Td to time at which time T1b is expected to have passed, and is determined in advance by an experiment or the like.

In the example shown in FIG. 2, the periodic pulse energization is started at time Tc. At time Tc, the first voltage V1 rises to the voltage value V1m, and the second voltage V2 rises to the voltage value V2m. The second switching element SW2 is turned off at time Tc, and then the second switching element SW2 repeats On and Off. As shown in FIG. 2, after time Tc, the phase of ON/OFF change of first switching element SW1 and the phase of ON/OFF change of the second switching element SW2 are opposite to each other. Both the first voltage V1 and the second voltage V2 are dropped and remain at a low voltage level, and the power saving operation of the solenoid valve 10 is achieved.

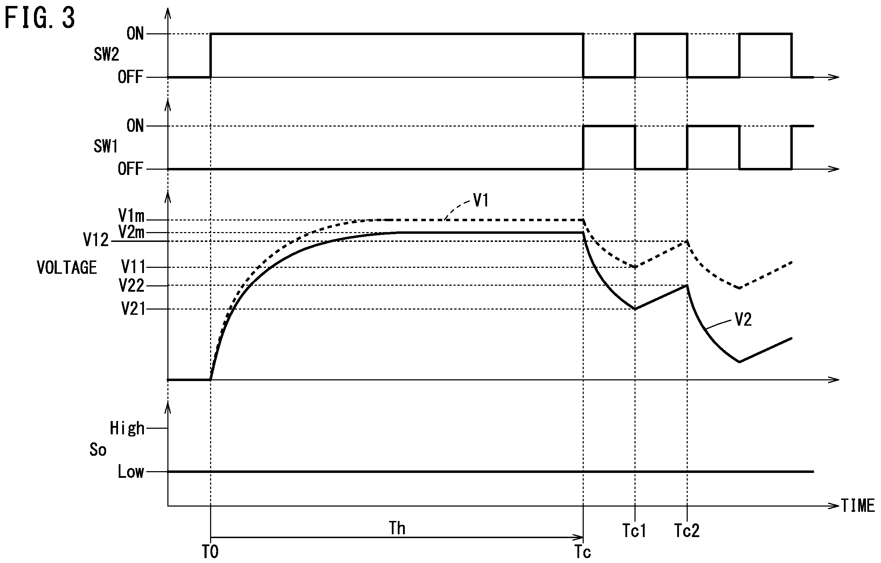

FIG. 3 is a diagram exemplifying changes in the first voltage V1 and the second voltage V2 with time in the case where the solenoid valve 10 does not open normally. FIG. 3 also exemplifies the change in the output signal So, the ON/OFF change of the first switching element SW1, and the ON/OFF change of the second switching element SW2.

In order to start driving the solenoid valve 10, the switching control unit 182 of the control unit 100 performs the second ON control on the second switching element SW2 and performs the first OFF control on the first switching element SW1 at time T0. The second switching element SW2 is turned on, and the first switching element SW1 is turned off. As described above, at time T0, the solenoid coil 30 is not energized in periodic pulses. The continuous energization is performed for the solenoid coil 30.

After the start of the driving of the solenoid valve 10, both the first voltage V1 and the second voltage V2 rise. However, as described above, the rise of the second voltage V2 is slower than the rise of the first voltage V1. Since the first voltage V1 is higher than the second voltage V2, the comparator 130 outputs the output signal So indicating the Low level from the output terminal N. The detection unit 186 detects that the first voltage V1 is higher than the second voltage V2 on the basis of the output signal So from the comparator 130. The solenoid valve 10 remains in the valve closed state.

Thereafter, when the first voltage V1 and the second voltage V2 rise, the solenoid valve 10 should open. However, the solenoid valve 10 might not open normally due to factors such as a low voltage applied from the power source E or sticking of the movable iron core 10a in the solenoid valve 10. In the case where the solenoid valve 10 does not open, the input voltage Vi does not drop. Therefore, the voltage drop of the first voltage V1 and the second voltage V2 does not occur.

The first state in which the first voltage V1 is higher than the second voltage V2 continues until time Tc after the predetermined time period Th has elapsed from time T0. Therefore, the comparator 130 continues to output the output signal So indicating the Low level from the output terminal N. In the case where the voltage dividing resistor Rv is not provided, the first state changes to a state in which the first voltage V1 and the second voltage V2 are equal to each other. However, since the state does not further change to the second state in which the first voltage V1 is lower than the second voltage V2, it is not essential to provide the voltage dividing resistor Rv.

In the present embodiment, the voltage dividing resistor Rv is provided in order to reduce the possibility that the first state changes to the second state temporarily or a plurality of times due to noise or the like. Therefore, in the case where the solenoid valve 10 does open, the first state is easily maintained by the voltage dividing resistor Rv. The voltage dividing resistor Rv reduces the risk of erroneously detecting the change in the state of the voltage at which the first state changes to the second state, and the valve open state can be detected more accurately.

When time Tc arrives, the periodic pulse energization is started for the purpose of the power saving operation. That is, the switching control unit 182 alternately repeats the second OFF control and the second ON control on the second switching element SW2. When the second switching element SW2 is turned from ON to OFF, the input voltage Vi drops for the first time after the start of the operation of the solenoid valve 10. In this case, a problem that may occur in the conventional signal output circuit will be described below.

In the conventional signal output circuit, in the case where the input voltage Vi drops, a change in the state of voltage in which the magnitude relationship between the two voltage values input to the comparator is reversed may occur due to a delay caused by smoothing of the input voltage Vi. In the case where the change in the state of the voltage is detected for the first time after the start of driving of the solenoid valve 10, the valve open state of the solenoid valve 10 can be detected by using, for example, an external device or the like. That is, there is a concern that the valve open state of the solenoid valve 10 may be erroneously detected in response to the start of the periodic pulse energization.

This problem is solved in the present embodiment. That is, in the signal output circuit 40 according to the present embodiment, the above-described change in the state of voltage does not occur in response to the start of the periodic pulse energization. The principle of this will be described below.

At time Tc shown in FIG. 3, the first voltage V1 rises to the voltage value V1m, and the second voltage V2 rises to the voltage value V2m. Since the first state in which the first voltage V1 is higher than the second voltage V2 is maintained, the comparator 130 continues to output the output signal So indicating the Low level from the output terminal N. As described above, the periodic pulse energization is started at time Tc. The switching control unit 182 alternately repeats the second OFF control and the second ON control on the second switching element SW2, and alternately repeats the first ON control and the first OFF control on the first switching element SW1.

After time Tc, the phase of ON/OFF change of first switching element SW1 and the phase of ON/OFF change of the second switching element SW2 are opposite to each other. Therefore, at time Tc, the second switching element SW2 changes from ON to OFF, and the first switching element SW1 changes from OFF to ON. Since the first smoothing circuit 110 is provided, the first voltage V1 does not drop rapidly but gradually. Since the charge stored in the second capacitor C2 is rapidly discharged by the discharge circuit 150, the second voltage V2 rapidly drops. Therefore, a voltage change in which the first voltage V1 becomes lower than the second voltage V2 does not occur.

From time Tc to subsequent time Tc1, the first voltage V1 drops to a voltage value V11 and the second voltage V2 drops to a voltage value V21. Since the charge accumulated in the second capacitor C2 is rapidly discharged, the second voltage V2 at time Tc1 is sufficiently lower than the first voltage V1. Since the first state in which the first voltage V1 is higher than the second voltage V2 is maintained also in the period from time Tc to time Tc1, the comparator 130 continues to output the output signal So indicating the Low level from the output terminal N.

As described above, after the solenoid valve 10 starts to be driven at time T0, the detection unit 186 detects that the first voltage V1 is higher than the second voltage V2 on the basis of the output signal So from the comparator 130. As described above, the first voltage V1 remains higher than the second voltage V2 even during the period from time Tc to time Tc1, and a voltage change in which the first voltage V1 becomes lower than the second voltage V2 does not occur. Therefore, even when the solenoid coil 30 is energized in periodic pulses, it is possible to prevent the solenoid valve 10 in the valve closed state from being erroneously detected as being in the valve open state.

At time Tc1, the second switching element SW2 changes from OFF to ON, and the first switching element SW1 changes from ON to OFF. From time Tc1 to subsequent time Tc2, the first voltage V1 rises to voltage value V12 and the second voltage V2 rises to voltage value V22. The rise of the second voltage V2 is slower than the rise of the first voltage V1.

Since the first state in which the first voltage V1 is higher than the second voltage V2 is maintained also in the period from time Tc1 to the time Tc2, the comparator 130 continues to output the output signal So indicating the Low level from the output terminal N. The detection unit 186 still detects that the first voltage V1 is higher than the second voltage V2 on the basis of the output signal So from the comparator 130.

At time Tc2, the second switching element SW2 changes from ON to OFF again, and the first switching element SW1 changes from OFF to ON again. Since the voltage changes in the same manner after the time Tc2, the above-described voltage change does not occur. Therefore, the comparator 130 continues to output the output signal So indicating the Low level from the output terminal N even after time Tc2. That is, in the present embodiment, it is possible to prevent the valve open state of the solenoid valve 10 from being erroneously detected in response to the start of the periodic pulse energization.

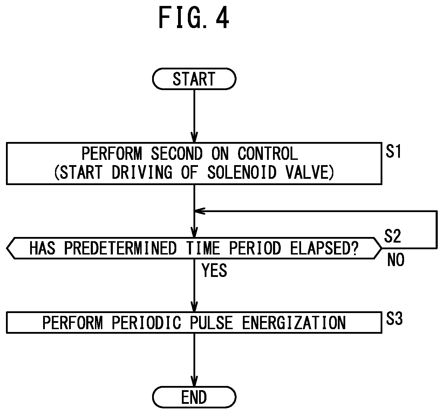

FIG. 4 is a flowchart illustrating an example of a processing sequence of a drive control for the drive circuit 20 of the solenoid valve 10. The present processing sequence is performed by, for example, the control unit 100 of the signal output circuit 40 executing a program stored in the memory. The present processing sequence is executed in response to the instruction by the user or the like of the solenoid valve 10 for the start of driving of the solenoid valve 10.

When the present processing sequence is started, in step S1, the switching control unit 182 of the control unit 100 performs the second ON control on the second switching element SW2. As a result, the driving of the solenoid valve 10 is started. The switching control unit 182 measures the elapsed time using a timer circuit, a clock circuit, or the like.

In step S2, the switching control unit 182 determines whether or not the predetermined time period Th has elapsed. In the case that the determination has become YES in step S2, the present processing sequence proceeds to step S3. In the case that the determination has become NO in step S2, the process of step S2 is repeated.

In step S3, the switching control unit 182 performs periodic pulse energization for the solenoid coil 30. That is, the switching control unit 182 alternately repeats the second OFF control and the second ON control on the second switching element SW2, and alternately repeats the first OFF control and the first ON control on the first switching element SW1. When the process of step S3 is completed, the present processing sequence comes to an end.

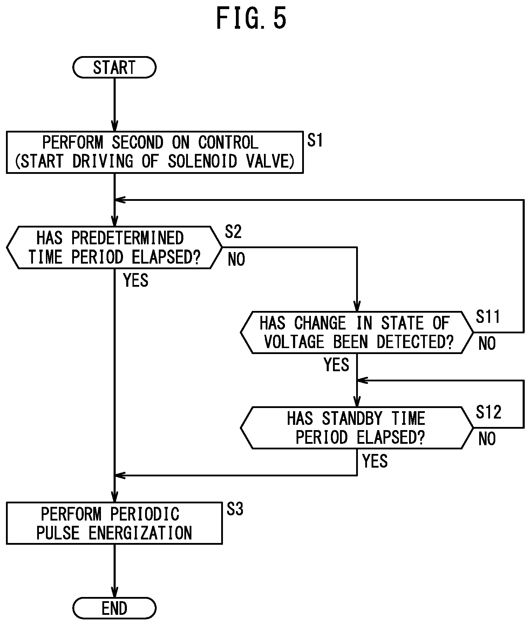

As described above, in the case where the first change in the state is detected by the detection unit 186 at time Td shown in FIG. 2, the switching control unit 182 may start the periodic pulse energization of the solenoid coil 30 before the predetermined time period Th elapses. FIG. 5 is a flowchart illustrating another example of a processing sequence of a drive control for the drive circuit 20 of the solenoid valve 10. In FIG. 5, the same reference numerals are given to the processes of the steps common to those in FIG. 4, and the description of the processes of these steps will be omitted below.

In the case where the determination has become NO in step S2, the present processing sequence proceeds to step S11. In step S11, the detection unit 186 determines whether or not the change in the state of voltage has been detected, on the basis of the output signal So from the comparator 130. The change in the state of voltage is a change from the first state in which the first voltage V1 is higher than the second voltage V2 to the second state in which the first voltage V1 is lower than the second voltage V2. In the case where the determination has become YES in step S11, the present processing sequence proceeds to step S12. In the case that the determination has become NO in step S11, the present processing sequence returns to step S2.

In step S12, the switching control unit 182 determines whether or not the standby time period has elapsed since the change in the state of voltage was detected in step S11. In the case where the determination has become YES in step S12, the present processing sequence proceeds to step S3. In the case that the determination has become NO in step S12, the process of step S12 is repeated.

In the present embodiment, as described above, the periodic pulse energization of the solenoid coil 30 is started at time Tc when the predetermined time period Th has elapsed from time T0. However, in the case where the periodic pulse energization is not performed, the signal output circuit 40 may not include the first smoothing circuit 110 and the discharge circuit 150. In this case, the signal output circuit 40 includes the control unit 100, the second smoothing circuit 120, the voltage dividing resistor Rv, and the comparator 130. The first voltage M1 input to the first input terminal V1 of the comparator 130 is equal to the input voltage Vi amplified by the amplifier 80.

As described above, the voltage dividing resistor Rv divides the smoothed voltage obtained by smoothing the input voltage Vi by the second smoothing circuit 120. The second voltage V2 obtained by dividing the smoothed voltage is input to the second input terminal M2 of the comparator 130. Therefore, in the case where the solenoid valve 10 does not open, the first state in which the first voltage V1 is higher than the second voltage V2 is maintained by the voltage dividing resistor Rv. The voltage dividing resistor Rv reduces the risk of erroneously detecting the change in the state of voltage at which the first state changes to the second state, and the valve open state can be detected more accurately.

Concerning the above-described disclosure, the following supplementary notes are further disclosed.

### (Supplementary Note 1)

The signal output circuit (40) for the solenoid valve (10) includes the first smoothing circuit (110) including the first capacitor (C1) and configured to smooth the input voltage (Vi) corresponding to the drive current flowing through the solenoid coil (30) configured to drive the solenoid valve, the second smoothing circuit (120) including the second capacitor (C2) and configured to smooth the input voltage, the second smoothing circuit having the time constant larger than the time constant of the first smoothing circuit, the comparator (130) including the first input terminal (M1) to which the first voltage (V1) obtained by smoothing the input voltage by the first smoothing circuit is input, the second input terminal (M2) to which the second voltage (V2) corresponding to the smoothed voltage obtained by smoothing the input voltage by the second smoothing circuit is input, and the output terminal (N) from which the output signal (So) based on the comparison between the first voltage and the second voltage is output, and the discharge circuit (150) connected to the second capacitor and configured to switch whether or not to discharge the electric charge accumulated in the second capacitor, wherein the discharge circuit includes the first switching element (SW1) and the discharge resistor (Rd) connected in series. In accordance with such a configuration, even in the case where the solenoid coil is energized in periodic pulses, it is possible to prevent the solenoid valve in the valve closed state from being erroneously detected as being in the valve open state.

### (Supplementary Note 2)

In the signal output circuit for the solenoid valve according to Supplementary Note 1, it is preferable for the capacitance of the second capacitor to be larger than the capacitance of the first capacitor. In accordance with such a configuration, the change in the second voltage can be delayed from the change in the first voltage.

### (Supplementary Note 3)

The signal output circuit for the solenoid valve according to Supplementary Note 1 may further include the amplifier (80) configured to amplify the input voltage, and each of the first smoothing circuit and the second smoothing circuit may smooth the input voltage amplified by the amplifier. In accordance with such a configuration, the signal output circuit can react sensitively to a change in the input voltage.

### (Supplementary Note 4)

The signal output circuit for the solenoid valve according to Supplementary Note 1 may further include the voltage dividing resistor (Rv) configured to divide the smoothed voltage, and the second voltage may be obtained by dividing the smoothed voltage by the voltage dividing resistor. In accordance with such a configuration, the first state in which the first voltage is higher than the second voltage can be maintained. The risk of erroneously detecting the change in the state of voltage in which the first state changes to the second state where the first voltage V1 is lower than the second voltage V2 is reduced, and the valve open state can be detected more accurately.

### (Supplementary Note 5)

The signal output circuit for the solenoid valve according to any one of Supplementary Notes 1 to 4 may further include the detection unit (186) configured to detect, on the basis of the output signal, the change in the state of the voltage, which is the change from the first state in which the first voltage is higher than the second voltage to the second state in which the first voltage is lower than the second voltage. In accordance with such a configuration, the detection of the change in the voltage can be associated with the detection of the valve open state of the solenoid valve.

### (Supplementary Note 6)

The signal output circuit for the solenoid valve according to Supplementary Note 5 may further include the switching control unit (182) configured to perform first ON control of turning on the first switching element to cause the discharge circuit to discharge the electric charge in the non-energized state in which the drive current does not flow through the solenoid coil, and first OFF control of turning off the first switching element in the energized state in which the drive current flows through the solenoid coil. In accordance with such a configuration, in the case where the solenoid coil changes from the energized state to the non-energized state, the electric charge accumulated in the second capacitor can be rapidly discharged.

### (Supplementary Note 7)

In the signal output circuit for the solenoid valve according to the Supplementary Note 6, the switching control unit may perform the second ON control of turning on the second switching element (SW2) connected to the solenoid coil in order to bring the solenoid coil into the energized state, and the second OFF control of turning off the second switching element in order to bring the solenoid coil into the non-energized state, when the predetermined time period (Th) elapses after the switching control unit performs the second ON control to start driving the solenoid valve, the switching control unit may alternately and repeatedly perform the second OFF control and the second ON control on the second switching element and alternately and repeatedly perform the first ON control and the first OFF control on the first switching element, and the first switching element and the second switching element may not be turned on simultaneously. In accordance with such a configuration, it is possible to realize the power saving operation of the solenoid valve while preventing the valve open state of the solenoid valve from being erroneously detected.

### (Supplementary Note 8)

In the signal output circuit for the solenoid valve according to Supplementary Note 7, in the case where the detection unit detects the change in the state before the predetermined time period elapses after the switching control unit performs the second ON control, the switching control unit may alternately and repeatedly perform the second OFF control and the second ON control on the second switching element before the predetermined time period elapses. In accordance with such a configuration, when the solenoid valve is normally opened, a high power saving effect can be obtained.

### (Supplementary Note 9)

In the drive control method for the solenoid valve by the drive circuit (20) including the signal output circuit for the solenoid valve according to any one of Supplementary Notes 1 to 4, the drive control method includes, the drive starting step of performing the second ON control of turning on the second switching element connected to the solenoid coil to bring the solenoid coil into the energized state in which the drive current flows through the solenoid coil, in order to start driving the solenoid valve, the pulse energization step of, in the case where he predetermined time period elapses after the second ON control is performed in the drive starting step, alternately and repeatedly performing, on the second switching element, the second OFF control of turning off the second switching element to bring the solenoid coil into the non-energized state in which the drive current does not flow through the solenoid coil and the second ON control, and alternately and repeatedly performing, on the first switching element, the first ON control of turning on the first switching element in the non-energized state to cause the discharge circuit to discharge the electric charge and the first OFF control of turning off the first switching element in the energized state, and the change in the state detection step of detecting, on the basis of the output signal, the change in the state of the voltage from the first state in which the first voltage is higher than the second voltage to the second state in which the first voltage is lower than the second voltage. In accordance with such a configuration, it is possible to realize the power saving operation of the solenoid valve while preventing the valve open state of the solenoid valve from being erroneously detected in the case where the solenoid valve is not opened normally.

### (Supplementary Note 10)

In the drive control method for the solenoid valve according to Supplementary Note 9, in the case where the change in the state is detected in the change in the state detection step before the predetermined time period elapses after the second ON control is performed in the drive starting step, the pulse energization step may be performed before the predetermined time period elapses. In accordance with such a configuration, the power saving effect of the normally opened solenoid valve is further enhanced.

It should be noted that the present invention is not limited to the disclosure described above, and various configurations could be adopted therein without departing from the essence and gist of the present invention.

## Claims

1. A signal output circuit (40) for a solenoid valve (10), the signal output circuit comprising:
a first smoothing circuit (110) including a first capacitor (C1) and configured to smooth an input voltage (Vi) corresponding to a drive current flowing through a solenoid coil (30) configured to drive the solenoid valve;
a second smoothing circuit (120) including a second capacitor (C2) and configured to smooth the input voltage, the second smoothing circuit having a time constant larger than a time constant of the first smoothing circuit;
a comparator (130) including a first input terminal (M1) to which a first voltage (V1) obtained by smoothing the input voltage by the first smoothing circuit is input, a second input terminal (M2) to which a second voltage (V2) corresponding to a smoothed voltage obtained by smoothing the input voltage by the second smoothing circuit is input, and an output terminal (N) from which an output signal (So) based on a comparison between the first voltage and the second voltage is output; and
a discharge circuit (150) connected to the second capacitor and configured to switch whether or not to discharge electric charge accumulated in the second capacitor,
wherein the discharge circuit includes a first switching element (SW1) and a discharge resistor (Rd) connected in series.

2. The signal output circuit for the solenoid valve according to claim 1,
wherein a capacitance of the second capacitor is larger than a capacitance of the first capacitor.

3. The signal output circuit for the solenoid valve according to claim 1, further comprising an amplifier (80) configured to amplify the input voltage,
wherein each of the first smoothing circuit and the second smoothing circuit smooths the input voltage amplified by the amplifier.

4. The signal output circuit for the solenoid valve according to claim 1, further comprising a voltage dividing resistor (Rv) configured to divide the smoothed voltage,
wherein the second voltage is obtained by dividing the smoothed voltage by the voltage dividing resistor.

5. The signal output circuit for the solenoid valve according to any one of claims 1 to 4, further comprising a detection unit (186) configured to detect, on a basis of the output signal, a change in a state of a voltage, which is a change from a first state in which the first voltage is higher than the second voltage to a second state in which the first voltage is lower than the second voltage.

6. The signal output circuit for the solenoid valve according to claim 5, further comprising a switching control unit (182) configured to perform first ON control of turning on the first switching element to cause the discharge circuit to discharge the electric charge in a non-energized state in which the drive current does not flow through the solenoid coil, and first OFF control of turning off the first switching element in an energized state in which the drive current flows through the solenoid coil.

7. The signal output circuit for the solenoid valve according to claim 6,
wherein the switching control unit performs second ON control of turning on a second switching element (SW2) connected to the solenoid coil in order to bring the solenoid coil into the energized state, and second OFF control of turning off the second switching element in order to bring the solenoid coil into the non-energized state,
when a predetermined time period (Th) elapses after the switching control unit performs the second ON control to start driving the solenoid valve, the switching control unit alternately and repeatedly performs the second OFF control and the second ON control on the second switching element and alternately and repeatedly performs the first ON control and the first OFF control on the first switching element, and
the first switching element and the second switching element are not turned on simultaneously.

8. The signal output circuit for the solenoid valve according to claim 7,
wherein in a case where the detection unit detects the change in the state before the predetermined time period elapses after the switching control unit performs the second ON control, the switching control unit alternately and repeatedly performs the second OFF control and the second ON control on the second switching element before the predetermined time period elapses.

9. A drive control method for a solenoid valve by a drive circuit (20) including the signal output circuit for the solenoid valve according to any one of claims 1 to 4, the drive control method comprising:
a drive starting step of performing second ON control of turning on a second switching element connected to the solenoid coil to bring the solenoid coil into an energized state in which the drive current flows through the solenoid coil, in order to start driving the solenoid valve;
a pulse energization step of, in a case where a predetermined time period elapses after the second ON control is performed in the drive starting step, alternately and repeatedly performing, on the second switching element, second OFF control of turning off the second switching element to bring the solenoid coil into a non-energized state in which the drive current does not flow through the solenoid coil and the second ON control, and alternately and repeatedly performing, on the first switching element, first ON control of turning on the first switching element in the non-energized state to cause the discharge circuit to discharge the electric charge and first OFF control of turning off the first switching element in the energized state; and
a change in a state detection step of detecting, on a basis of the output signal, a change in a state of a voltage from a first state in which the first voltage is higher than the second voltage to a second state in which the first voltage is lower than the second voltage.

10. The drive control method for the solenoid valve according to claim 9,
wherein in a case where the change in the state is detected in the change in the state detection step before the predetermined time period elapses after the second ON control is performed in the drive starting step, the pulse energization step is performed before the predetermined time period elapses.
